Europäisches Patentamt

European Patent Office

Office européen des brevets

(19)

(11) Numéro de publication : **0 493 192 B1**

(12) **FASCICULE DE BREVET EUROPEEN**

(45) Date de publication du fascicule du brevet :
21.06.95 Bulletin 95/25

(51) Int. Cl.⁶ : **H03F 3/21, H03F 1/56**

(21) Numéro de dépôt : **91403424.4**

(22) Date de dépôt : **17.12.91**

(54) **Dispositif de couplage de charge pour émetteur de forte puissance.**

(30) Priorité : **27.12.90 FR 9016332**

(43) Date de publication de la demande :
**01.07.92 Bulletin 92/27**

(45) Mention de la délivrance du brevet :
**21.06.95 Bulletin 95/25**

(84) Etats contractants désignés :
**CH DE FR GB LI**

(56) Documents cités :
**EP-A- 0 255 652**
**US-A- 3 482 179**

(73) Titulaire : **THOMSON-CSF**
**173, Boulevard Haussmann**
**F-75008 Paris (FR)**

(72) Inventeur : **Boulzaguet, Guy**
**THOMSON-CSF,**
**SCPI,**
**Cédex 67**
**F-92045 Paris la Défense (FR)**
Inventeur : **Penet, Guy-Arnaud**
**THOMSON-CSF,**
**SCPI,**
**Cédex 67**
**F-92045 Paris la Défense (FR)**

(74) Mandataire : **Lincot, Georges et al**
**THOMSON-CSF,**
**SCPI,**
**B.P. 329,**
**50, rue Jean-Pierre Timbaud**
**F-92402 Courbevoie Cédex (FR)**

## Description

La présente invention concerne un dispositif de couplage de charge pour émetteur de forte puissance.

Elle s'applique notamment à la réalisation d'émetteurs radioélectriques ou acoustiques de forte puissance supérieure par exemple à 100Kw émettant dans des bandes de fréquences comprises entre 5KHz et 2MHz.

Pour accroître la puissance de sortie de ces émetteurs; il est connu de connecter en parallèle un nombre déterminé d'amplificateurs soit par couplage direct, soit par couplage par transformateur hybride, soit encore par couplage par pont.

Cependant aucun de ces modes de couplage ne permet d'obtenir des réalisations d'émetteurs qui possèdent à la fois un très bon rendement énergétique, une modularité suffisante, des impédances de sortie élevées en dehors de la bande passante utile et qui assurent un découplage des sources de tensions appliquées sur les amplificateurs.

Le but de l'invention est de pallier les inconvénients précités.

A cet effet, l'invention a pour objet un dispositif de couplage de charge pour émetteur de forte puissance comportant un nombre déterminé N d'amplificateurs couplés ensemble par une entrée de signal commune caractérisé en ce qu'il comprend d'une part, un nombre déterminé N d'inductances identiques égal au nombre N d'amplificateurs reliées respectivement par une extrémité à la sortie d'un amplificateur et par leur deuxième extrémité à un point de liaison commun, et d'autre part, au moins un condensateur relié entre le point de liaison commun et une impédance de charge de l'émetteur.

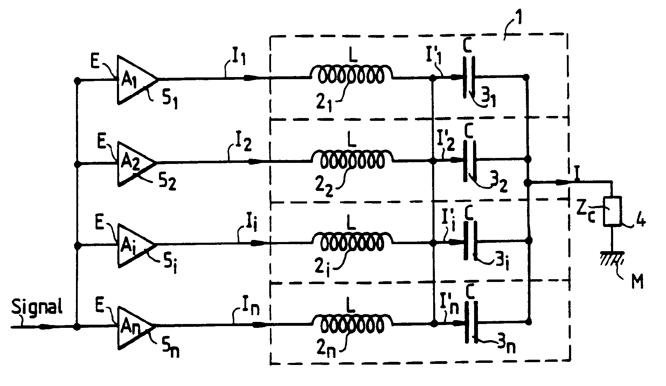

D'autres caractéristiques et avantages de l'invention apparaîtront au cours de la description qui suit, faite en regard de la figure unique annexée, données uniquement à titre d'exemple qui représente un mode de réalisation d'un dispositif de couplage de charge selon l'invention.

Le dispositif de couplage qui est représenté sur la figure unique à l'intérieur d'une ligne formée en pointillés 1 comprend un nombre déterminé N d'inductances $2_1$ ... $2_N$ reliées ensemble par une de leur extrémité à des premières extrémités également commune de N condensateurs, $3_1$ à $3_N$ placés en parallèle. Les deuxièmes extrémités communes des N condensateurs $3_1$ à $3_N$ sont reliées à un circuit de masse M servant de référence de potentiel à l'ensemble du dispositif de couplage par l'intermédiaire d'une impédance de charge 4. Les extrémités libres des N inductances $2_1$ ... $2_N$ sont reliées respectivement aux sorties de N amplificateurs $5_1$ à $5_N$ couplés par une entrée E de signal commune.

En désignant respectivement par $V_i$ et $I_i$ la tension et le courant fournis par un amplificateur $5_i$, par L et C les valeurs d'inductance et de capacité de l'inductance $Z_i$ et du condensateur $3_i$, par $i'_i$ le courant traversant l'impédance de durée 4, la tension $V_i$ fournie par l'amplificateur $5_i$ vérifie la relation

$$V_i = jL\omega i_1 - j/c\omega\, i'_1 + Z_c\, i. \quad (1)$$

En se plaçant dans un cas où toutes les inductances et capacités ont des valeurs identiques, et en additionnant l'ensemble des tensions $V_i$ fournies par chacun des amplificateurs $5_1$ à $5_N$, en écrivant que le courant i circulant dans la charge 4 est égale à la somme des courants $i_1$ à $i_N$, la $\Sigma V_i$ vérifie la relation

$$\Sigma V_i = (j/c\omega)(LC\omega^2 - 1)i + nZ_ci \quad (2)$$

Pour une fréquence de fonctionnement de l'émetteur qui annule la qualité $LC\omega^2-1$ le courant i traversant la charge 4 est alors déterminé par la relation

$$i = \frac{\Sigma V_i}{N.Zc} \quad (3)$$

En se plaçant dans le cas où l'impédance de charge Z est purement résistive et égale à R et en adoptant une valeur égale à 1 pour le quotient $L\omega/R$, le courant $i_i$ traversant chaque inductance $2_i$ a pour valeur

$$i_i = \frac{\delta V_i}{R} + \frac{\Sigma V_i}{NR}(1 + j)$$

et un argument $\varnothing_i$ vérifiant la relation

$$\varnothing_i = \text{Arctg}(\frac{\Sigma V_i - N, V_i}{\Sigma V_i})$$

A l'équilibre lorsque chaque amplificateur délivre la même tension $V_i = V_0$ le courant I dans la charge R devient $I = nV_o/R$ et le courant $I_i$ fourni par chaque amplificateur devient $I_i = V_o/R$.

Par contre si un déséquilibre se produit, se traduisant par exemple par la fourniture d'une tension nulle à la sortie d'un ou plusieurs amplificateurs $A_i$, un déphasage se produit alors entre la tension et le courant appliqué sur la charge égal à Arctg(a/N-a) où a désigne le nombre d'amplificateurs mis en circuit ouvert. Il est alors nécessaire de reconfigurer les étages d'émission pour rétablir un ensemble où tous les amplificateurs produisent un signal simultanément. Cette reconfiguration peut être réalisée de façon connue au moyen d'interrupteurs non représentés pour isoler chaque sortie d'amplificateur d'effectueuse de la charge de l'émetteur. Naturellement le circuit de recouplage qui vient d'être décrit peut encore subir d'autres adaptations consistant par exemple à n'utiliser qu'un seul condensateur de capacité nC au lieu de N condensateurs de capacité C si les caractéristiques électriques de l'émetteur le permettent.

## Revendications

1.  Dispositif de couplage de charge pour émetteur de forte puissance comportant un nombre déterminé N d'amplificateurs ($5_1$ ... $5_N$) couplés en-

semble par une entrée de signal commune caractérisé en ce qu'il comprend d'une part, un nombre déterminé N d'inductances à peu près identiques égal au nombre N d'amplificateurs reliées respectivement par une extrémité à la sortie d'un amplificateur ($5_I$) et par leur deuxième extrémité à un point de liaison commun, et d'autre part, au moins un condensateur relié entre le point de liaison commun et une impédance de charge de l'émetteur.

2. Dispositif selon la revendication 1, caractérisé en ce qu'il comprend N condensateurs dont des valeurs de capacitance à peu près identiques.

3. Utilisation du dispositif selon l'une quelconque des revendications 1 et 2 dans un émetteur d'onde radioélectrique.

4. Utilisation du dispositif selon l'une quelconque des revendications 1 et 2 dans un émetteur d'ondes acoustiques.

**Patentansprüche**

1. Lastankopplungsanordnung für Hochleistungssender mit einer bestimmten Anzahl N von Verstärkern ($5_1 ... 5_N$), die durch einen gemeinsamen Signalanschluß zusammengeschaltet sind, dadurch gekennzeichnet, daß sie einerseits eine bestimmte, der Anzahl N von Verstärkern gleiche Anzahl N von nahezu gleichen Induktivitäten enthält, die jeweils mit einem Ende an den Ausgang eines Verstärkers ($5_I$) und mit dem zweiten Ende an einen gemeinsamen Verbindungspunkt angeschlossen sind, und andrerseits wenigstens einen Kondensator, der zwischen dem gemeinsamen Verbindungspunkt und einer Lastimpedanz des Senders angeschlossen ist.

2. Anordnung nach Anspruch 1, dadurch gekennzeichnet, daß sie N Kondensatoren mit nahezu gleichen Kapazitäten enthält.

3. Verwendung der Anordnung nach einem der Ansprüche 1 und 2 in einem Sender von elektromagnetischen Wellen.

4. Verwendung der Anordnung nach einem der Ansprüche 1 und 2 in einem Sender von akustischen Wellen.

**Claims**

1. Load-coupling device for a high-power transmitter including a defined number N of amplifiers ($5_1 ... 5_N$) coupled together by a common signal input, characterized in that it comprises, on the one hand, a defined number N of virtually identical inductors equal to the number N of amplifiers and connected respectively by one end to the output of an amplifier ($5_I$) and by their second end to a common linking point, and, on the other hand, at least one capacitor connected between the common linking point and a load impedance of the transmitter.

2. Device according to Claim 1, characterized in that it comprises N capacitors, the capacitance values of which are virtually identical.

3. Use of the device according to any one of Claims 1 and 2 in a radio frequency wave transmitter.

4. Use of the device according to any one of Claims 1 and 2 in an acoustic wave transmitter.